# EUROPÄISCHE PATENTSCHRIFT

(11) **EP 3 910 266 B1**
(45) Veröffentlichungstag und Bekanntmachung des Hinweises auf die Patenterteilung: **31.08.2022**
(21) Anmeldenummer: 21170070.3
(22) Anmeldetag: 23.04.2021
(51) Int. Cl.: F25B 41/35, F16K 31/04, G01R 33/07, F16K 31/08

(54) **EXPANSIONSVENTILANORDNUNG FÜR EINEN KÄLTE- ODER KLIMAKREISLAUF**
EXPANSION VALVE ASSEMBLY FOR A REFRIGERATION OR AIR CONDITIONING CIRCUIT
AGENCEMENT DE VANNE D'EXPANSION POUR UN CIRCUIT DE RÉFRIGÉRATION OU DE CLIMATISATION

(30) Priorität: 11.05.2020 DE 102020112658
(43) Veröffentlichungstag der Anmeldung: 17.11.2021
(73) Patentinhaber: Pierburg GmbH, 41460 Neuss (DE)
(72) Erfinder: GERARDS, Hans, 52538 Gangelt (DE); BÜRGER, Frank, 52379 Langerwehe (DE); BEUTLER, Richard, 41564 Kaarst (DE)
(74) Vertreter: terpatent Patentanwälte ter Smitten Eberlein-Van Hoof Rütten Daubert

(56) Entgegenhaltungen:
- EP-A1- 2 801 771
- WO-A1-2019/062057
- US-A1- 2014 291 562

## Beschreibung

Die Erfindung betrifft eine Expansionsventilanordnung für einen Kälte- oder Klimakreislauf bestehend aus einem Strömungsgehäuse mit einem Einlass und einem Auslass, einem Synchronmotor mit einem Motorgehäuse, der über eine Gewindeanordnung mit einem Kopplungselement mit einem Regelkörper wirkverbunden ist, derart, dass das Kopplungselement mit dem Regelkörper axial bewegbar ist, mindestens einem Durchströmungsquerschnitt zwischen dem Einlass und dem Auslass, der von einem Ventilsitz umgeben ist, und der mittels des Regelkörpers verschließbar und freigebbar ist.

Expansionsventilanordnungen dienen dazu, den Druck des Arbeitsfluids durch Drosselung des zur Verfügung stehenden Durchströmungsquerschnitts zu verringern und das Volumen des Arbeitsfluids zu erhöhen, dieses also zu expandieren. Durch die Verwendung geregelter Expansionsventile kann dabei sowohl der Druckabfall und damit die Volumenzunahme geregelt werden als auch der Fluidstrom nahezu vollständig unterbrochen werden.

In Kälte- oder Klimakreisläufen werden diese Ventilanordnungen vor den Verdampfern und hinter den Verflüssigern angeordnet. Durch die Volumenzunahme wird das Arbeitsfluid teilweise verdampft, während das noch flüssige Arbeitsfluid im Verdampfer Wärme aufnimmt, wodurch auch der flüssige Teil verdampft. Dieses nun gasförmige Arbeitsfluid wird einem Kompressor zugeführt und verdichtet, um anschließend im Verflüssiger wieder in den flüssigen Aggregatzustand umgewandelt zu werden, wodurch der geschlossene Kreislauf gebildet wird. Diesem Kreislauf kann entsprechend Wärme oder Kälte im Bereich der Verdampfer und Verflüssiger entnommen werden.

Aus der DE 10 2017 122 624 A1 ist eine Expansionsventilanordnung bekannt, die einen elektromagnetisch betätigten Aktor aufweist. Der axial bewegbare Regelkörper dieses Ventils ist kolbenförmig und regelt einen ersten und einen zweiten Durchströmungsquerschnitt zwischen einem Einlass und dem Auslass. Zwischen den die Durchströmungsquerschnitte radial begrenzenden Ventilsitzen ist ein Ringspalt ausgebildet, durch den das Kältemittel vom Einlass zum Auslass zwischen dem im Wesentlichen kolbenförmigen Regelkörper und den Ventilsitzen strömen kann. Zur Lagerückmeldung eines Kopplungselementes in Form eines Ankers, der mit dem Ventil verbunden ist, kann ein magnetoresistiver Sensor im Bereich eines Steckers vorgesehen sein.

Aus der US 4,593,881 ist eine gattungsgemäße Expansionsventilanordnung bekannt, bei der der Aktor als Steppermotor ausgebildeter Synchronmotor ausgebildet ist, dessen Drehbewegung mittels einer Gewindeanordnung auf ein Kopplungselement mit einem Regelkörper zur axialen Bewegung wirkverbunden ist. Hierbei ist zur Ansteuerung ein extern angeordneter Temperatursensor vorgesehen. WO 2019/062057 A1 offenbart eine Expansionsventilanordnung, bei der der Rotor mit dem Kopplungselement direkt drehfest verbunden ist, während das Innengewindeteil fest mit dem Ventilblock relativ zum Ventilsitz verbunden ist. Der Rotor dreht sich somit relativ zum statischen Innengewindeteil. Die Kraftübertragung des Rotors auf die axiale Bewegung des Kopplungselementes erfolgt über Federkräfte.

Sämtliche Anordnungen weisen jedoch hinsichtlich der Ansteuerung der Ventilanordnung immer noch Ungenauigkeiten und Verzögerungen auf.

Vor diesem Hintergrund stellt sich die Aufgabe, eine Expansionsventilanordnung bereit zu stellen, die auf einfache und kostengünstige Weise die oben genannten Nachteile vermeidet.

Diese Aufgabe wird erfindungsgemäß dadurch gelöst, dass der Synchronmotor als Spaltrohrmotor ausgebildet ist, in dessen Spalttopf eine Rotoranordnung mit einem Rotorzylinderteil auf dem in Längsrichtung verlaufende, hinsichtlich der Polarität abwechselnd angeordneten Permanentmagnetbereiche vorgesehen sind, wobei das Rotorzylinderteil über Rotorverbindungsmittel drehfest mit einem Innengewindeteil verbunden ist, das auf ein Außengewinde des Kopplungselementes angreift, wobei das Innengewindeteil über Lagermittel drehbar im Strömungsgehäuse gelagert ist, wobei im Motorgehäuse ein Hall-Sensor zur Positionserkennung des Rotorzylinderteils vorgesehen ist. Hierdurch ist es möglich, die Expansionsventilanordnung besonders einfach aufzubauen und gleichzeitig eine sehr präzise Lageerkennung vorzusehen. Unter Positionserkennung wird hierbei sowohl das Erkennen einer Positionsabweichung als auch im Falle einer geeigneten Steuerungslogik das Erfassen und das damit verbundene Bestimmen einer Absolutposition verstanden. Eine Expansionsventilanordnung gemäß Erfindung ist in Anspruch 1 definiert.

Vorzugsweise ist ein Stator des Spaltrohrmotors als Klauenpolstator ausgebildet. Hierdurch wird auf besonders kostengünstige Weise ein einfach herzustellender Stator bereitgestellt, der ein ausreichendes Drehmoment zur Verfügung stellt.

In besonders vorteilhafter Weise ist ein Spalttopf des Spaltrohrmotors abgedichtet im Strömungsgehäuse eingeklemmt. Hierdurch ist eine besonders einfache und sichere Montage gewährleistet. Dabei kann in vorteilhafter Weise der Spalttopf als Blechteil hergestellt sein, dessen rohrförmiger Teil im Klauenpolstator gelagert ist, wodurch die Montierbarkeit noch weiter vereinfacht wird.

Dadurch, dass die Rotorverbindungsmittel für das Gewindehohlteil glockenförmig ausgebildet sind, wobei das Kopplungselement durch dessen Bodenteil führbar ist, wird eine besonders kompakte Expansionsventilanordnung erreicht, bei der zudem das Kopplungselement auf einfache Weise geführt ist.

In besonders vorteilhafter Weise ist der Hall-Sensor als Dual-Hallsensor mit zwei Hallebenen ausgebildet. Hierdurch ist es möglich, auf einfache Weise sowohl die Position als auch die Drehrichtung des Rotorzylinderteils zu ermitteln.

In besonders vorteilhafter Weise sind die Permanentmagnetbereiche in Form eines zylinderförmigen, gespritzten kunststoffgebundenen Magneten ausgebildet. Der Rotorzylinderteil besteht zumindest zum Teil aus einem Ringmagnet, welcher am Umfang abwechselnd magnetische Nord- und Südpole aufweist.

Alternativ können die Permanentmagnetbereiche als Permanentmagnetstreifen ausgebildet sein, die in entsprechenden Aussparungen des Rotorzylinderteils angeordnet sind.

Auch ist es besonders vorteilhaft für die Kompaktheit der Expansionsventilanordnung, wenn im Motorgehäuse eine Steuerungseinheit vorgesehen ist, an der der Hall-Sensor angeordnet ist.

In besonders vorteilhafter Weise ist der Spaltrohrmotor zweiphasig, wodurch ein sehr gleichmäßiges, hohes Drehmoment bereitstellbar ist. Dadurch, dass Phasen, insbesondere die zwei Phasen, des Spaltrohrmotors sinusförmig ansteuerbar sind, ist eine besonders genaue Positionierung des Rotorzylinderteils möglich.

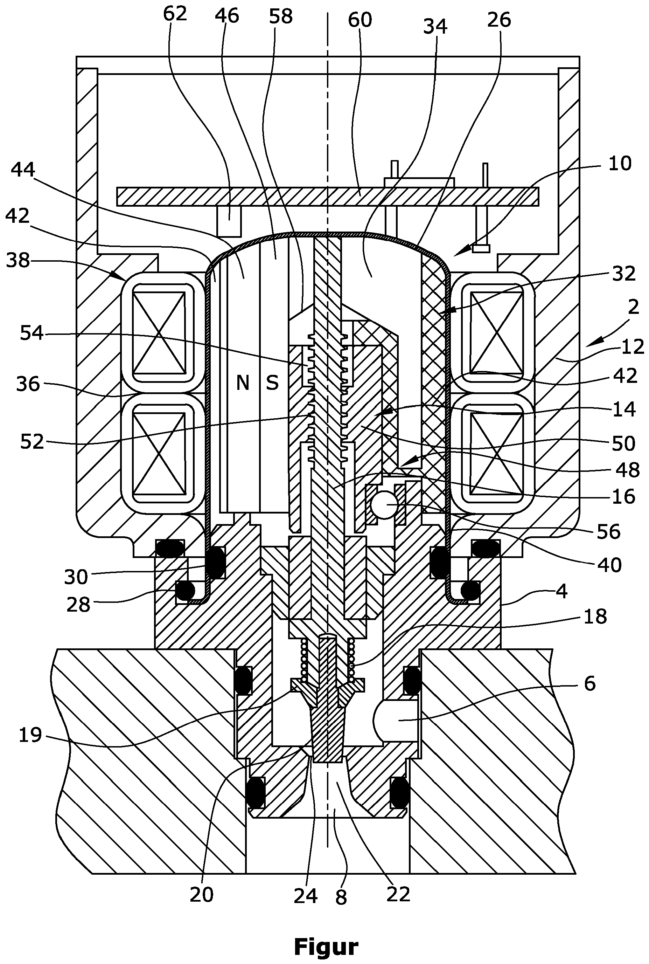

Ein Ausführungsbeispiel einer erfindungsgemäßen Expansionsventilanordnung für einen Kälte- oder Klimakreislauf ist in der Figur dargestellt und wird nachfolgend beschrieben.

Die Figur zeigt einen Ausschnitt einer Seitenansicht einer erfindungsgemäßen Expansionsventilanordnung in geschnittener Darstellung.

Eine erfindungsgemäße Expansionsventilanordnung 2 für einen Kälte -oder Klimakreislauf besitzt ein Strömungsgehäuse 4 mit einem Einlass 6 und einem Auslass 8. Hierbei wird der Einlass 6 auf bekannte Weise mit einem nicht dargestellten Verflüssiger verbunden, um ein Arbeitsfluid über den Auslass 8 zu einem nicht dargestellten Verdampfer zu führen. Um eine Drosselung des Arbeitsfluids zu ermöglichen, ist ein Synchronmotor 10 mit einem Motorgehäuse 12 vorgesehen, wobei der Synchronmotor 10 über eine Gewindeanordnung 14 mit einem Kopplungselement 16 verbunden ist. Das Kopplungselement 16 weist wiederum auf bekannte Weise einen mittels einer Feder 18 federnd gelagerten Dichtkörper 19 auf den sich ein Regelkörper 20 anschließt. Dieser Regelkörper 20, der wie nachfolgend noch beschrieben wird, axial bewegbar ist, steht auf bekannte Weise in Wirkverbindung mit einem Durchströmungsquerschnitt 22, der, in Strömungsrichtung gesehen, zwischen dem Einlass 6 und dem Auslass 8 vorgesehen ist. Dieser Durchströmungsquerschnitt 22 ist auf bekannte Weise von einem Ventilsitz 24 umgeben, sodass der Durchströmungsquerschnitt 22 mittels des Regelkörpers 20 verschließbar und freigebbar ist, sodass eine Drosselung des Arbeitsfluids ermöglicht wird.

Der Synchronmotor 10 ist als sogenannter Spaltrohrmotor ausgebildet, der im vorliegenden Ausführungsbeispiel ein aus einem Blechteil hergestellten Spalttopf 26 aufweist, der über einen Stützring 28 und eine Abdichtung 30 abgedichtet im Strömungsgehäuse 4 eingeklemmt ist. Der Spalttopf 26 nimmt auf bekannte Weise eine Rotoranordnung 32 auf, sodass ein Rotorraum 34 auf bekannte Weise gegenüber einem Statorraum 36 eines Stators 38 des Synchronmotors 10 abgedichtet ist. Der Stator 38 ist im vorliegenden Ausführungsbeispiel als Klauenpolstator ausgebildet. Die Endmontage der Expansionsventilanordnung 2 ist aufgrund des oben geschilderten Aufbaus sehr einfach zu realisieren. Hierzu wird das Strömungsgehäuse 4 mit dem darin befestigten Spalttopf 26 und der innenliegenden Rotoranordnung 32 in das Motorgehäuse 12 geschoben, wobei ein rohrförmiger Teil 40 des Spalttopfes 26 im Klauenpolstator 38 gelagert wird.

Die Rotoranordnung 32 weist im Wesentlichen ein Rotorzylinderteil 42 auf, auf dem in Längsrichtung verlaufende, hinsichtlich der Polarität sich abwechselnde Permanentmagnetbereiche 44, 46 vorgesehen sind. Diese Permanentmagnetbereiche 44, 46 sind in Form eines zylinderförmigen, gespritzten kunststoffgebundenen Magneten ausgebildet. Der Spaltrohrmotor 10 wird im vorliegenden Ausführungsbeispiel zweiphasig angetrieben. Diese beiden Phasen werden dabei sinusförmig angesteuert.

Das Rotorzylinderteil 42 ist über Rotorverbindungsmittel 48 drehfest mit einem Innengewindeteil 50 verbunden. Ein Innengewinde 52 des Innengewindeteils 50 greift auf ein Außengewinde 54 des Kopplungselementes 16 an. Das Innengewindeteil 50 ist dabei über Lagermittel 56 drehbar im Strömungsgehäuse 4 gelagert. Hierdurch ist es möglich auf einfache Weise die Drehbewegung des Rotorzylinderteils 42 in eine Axialbewegung des Kopplungselementes 16 zu überführen. Um die Expansionsventilanordnung 2 besonders kompakt zu gestalten, sind die Rotorverbindungsmittel 48 für das Innengewindeteil 50 glockenförmig ausgebildet, wobei das Kopplungselement 16 durch ein Bodenteil 58 der Rotorverbindungsmittel 48 hindurchreicht.

Um auf besonders einfache und sichere Weise eine Lageerkennung durchzuführen, ist an einer Steuerungseinheit 60 des Spaltrohrmotors 10 ein Dual-Hall-Sensor 62 im Bereich einer Längserstreckung des Rotorzylinderteil 42 vorgesehen, wobei der Dual-Hall-Sensor 62 zwei HallEbenen aufweist, um sowohl die Position als auch die Drehrichtung des Rotorzylinderteils 42 ermitteln zu können.

## Patentansprüche

1. Expansionsventilanordnung für einen Kälte- oder Klimakreislauf bestehend aus:
einem Strömungsgehäuse (4) mit einem Einlass (6) und einem Auslass (8),
einem Synchronmotor (10) mit einem Motorgehäuse (12), der über eine Gewindeanordnung (14) mit einem Kopplungselement (16) mit einem Regelkörper (20) wirkverbunden ist, derart, dass das Kopplungselement (16) mit dem Regelkörper (20) axial bewegbar ist, mindestens einem Durchströmungsquerschnitt (22) zwischen dem Einlass (6) und dem Auslass (8), der von einem Ventilsitz (24) umgeben ist, und der mittels des Regelkörpers (20) verschließbar und freigebbar ist,
wobei
der Synchronmotor (10) als Spaltrohrmotor ausgebildet ist, in dessen Spalttopf (26) eine Rotoranordnung (32) mit einem Rotorzylinderteil (42), Rotorverbindungsmittel (48), ein Innengewindeteil (50) und Lagermittel (56) angeordnet sind, wobei auf dem Rotorzylinderteil (42) in Längsrichtung verlaufende, hinsichtlich der Polarität abwechselnd angeordnete Permanentmagnetbereiche (44, 46) vorgesehen sind, wobei das Rotorzylinderteil (42) über die Rotorverbindungsmittel (48) drehfest mit dem Innengewindeteil (50) verbunden ist, das auf ein Außengewinde (54) des Kopplungselementes (16) angreift, wobei das Innengewindeteil (50) über die Lagermittel (56) drehbar im Strömungsgehäuse (4) gelagert ist,
wobei im Motorgehäuse (12) ein Hall-Sensor (62) zur Positionserkennung des Rotorzylinderteils (42) vorgesehen ist.

2. Expansionsventilanordnung für einen Kälte- oder Klimakreislauf nach Anspruch 1, wobei ein Stator (38) des Spaltrohrmotors (10) als Klauenpolstator ausgebildet ist.

3. Expansionsventilanordnung für einen Kälte- oder Klimakreislauf nach Anspruch 1 oder 2, wobei der Spalttopf (26) des Spaltrohrmotors (10) abgedichtet im Strömungsgehäuse (4) eingeklemmt ist.

4. Expansionsventilanordnung für einen Kälte- oder Klimakreislauf nach den Ansprüchen 2 und 3, wobei der Spalttopf (26) als Blechteil hergestellt ist, dessen rohrförmiger Teil (40) im Klauenpolstator (38) gelagert ist.

5. Expansionsventilanordnung für einen Kälte- oder Klimakreislauf nach einem der vorhergehenden Ansprüche, wobei die Rotorverbindungsmittel (48) für das Innengewindeteil (50) glockenförmig ausgebildet sind, wobei das Kopplungselement (16) durch dessen Bodenteil (58) führbar ist.

6. Expansionsventilanordnung für einen Kälte- oder Klimakreislauf nach einem der vorhergehenden Ansprüche, wobei der Hall-Sensor (62) als Dual-Hallsensor mit zwei Hallebenen ausgebildet ist.

7. Expansionsventilanordnung für einen Kälte- oder Klimakreislauf nach einem der vorhergehenden Ansprüche, wobei die Permanentmagnetbereiche (44, 46) in Form eines zylinderförmigen, gespritzten kunststoffgebundenen Magneten ausgebildet sind.

8. Expansionsventilanordnung für einen Kälte- oder Klimakreislauf nach einem der Ansprüche 1 - 6, wobei die Permanentmagnetbereiche (44, 46) als Permanentmagnetstreifen ausgebildet sind, die in entsprechenden Aussparungen des Rotorzylinderteils (42) angeordnet sind.

9. Expansionsventilanordnung für einen Kälte- oder Klimakreislauf nach einem der vorhergehenden Ansprüche, wobei im Motorgehäuse (12) eine Steuerungseinheit (60) vorgesehen ist, an der der Hall-Sensor (62) angeordnet ist.

10. Expansionsventilanordnung für einen Kälte- oder Klimakreislauf nach einem der vorhergehenden Ansprüche, wobei der Spaltrohrmotor (10) zweiphasig ist.

11. Expansionsventilanordnung für einen Kälte- oder Klimakreislauf nach einem der vorhergehenden Ansprüche, wobei Phasen des Spaltrohrmotors (10) sinusfömig ansteuerbar sind.

## Claims

1. Expansion valve arrangement for a cooling or air-conditioning circuit consisting of:
a flow housing (4) with an inlet (6) and an outlet (8),
a synchronous motor (10) with a motor housing (12), which synchronous motor (10) is, via a thread arrangement (14), operatively connected to a coupling element (16) with a control body (20), in such a way that the coupling element (16) with the control body (20) can be moved axially, at least one flow cross-section (22) between the inlet (6) and the outlet (8), which flow cross-section (22) is surrounded by a valve seat (24) and can be closed and opened by means of the control body (20),
wherein
the synchronous motor (10) is a canned motor, within a can (26) of which a rotor arrangement (32) is arranged, which rotor arrangement (32) comprises a rotor cylinder part (42), rotor connecting means (48), an internal thread part (50) and bearing means (56), wherein permanent magnet regions (44, 46), which extend in the longitudinal direction and are arranged alternately with respect to polarity, are provided on the rotor cylinder part (42), wherein the rotor cylinder part (42) is, via the rotor connecting means (48), co-rotatably connected with the internal thread part (50) which engages an external thread (54) of the coupling element (16), wherein the internal thread part (50) is rotatably supported in the flow housing (4) via the bearing means (56), wherein a Hall sensor (62) is provided in the motor housing (12) for detecting a position of the rotor cylinder part (42).

2. Expansion valve arrangement for a cooling or air-conditioning circuit according to claim 1, wherein a stator (38) of the canned motor (10) is a claw-pole stator.

3. Expansion valve arrangement for a cooling or air-conditioning circuit according to claim 1 or 2, wherein the can (26) of the canned motor (10) is clamped in the flow housing (4) in a sealed manner.

4. Expansion valve arrangement for a cooling or air-conditioning circuit according to claims 2 and 3, wherein the can (26) is a sheet metal part, a tubular part (40) of which is supported in the claw-pole stator (38).

5. Expansion valve arrangement for a cooling or air-conditioning circuit according to one of the preceding claims, wherein the rotor connecting means (48) for the internal thread part (50) are bell-shaped, wherein the coupling element (16) can be guided via a bottom part (58) of the rotor connecting means (48).

6. Expansion valve arrangement for a cooling or air-conditioning circuit according to one of the preceding claims, wherein the Hall sensor (62) is a dual Hall sensor with two Hall levels.

7. Expansion valve arrangement for a cooling or air-conditioning circuit according to one of the preceding claims, wherein the permanent magnet regions (44, 46) are realized as a cylindrical, injection-molded plastic-bonded magnet.

8. Expansion valve arrangement for a cooling or air-conditioning circuit according to one of claims 1 - 6, wherein the permanent magnet areas (44, 46) are realized as permanent magnet strips which are arranged in corresponding recesses of the rotor cylinder part (42).

9. Expansion valve arrangement for a cooling or air-conditioning circuit according to one of the preceding claims, wherein a control unit (60) is provided in the motor housing (12), at which control (60) the Hall sensor (62) is arranged.

10. Expansion valve arrangement for a cooling or air-conditioning circuit according to one of the preceding claims, wherein the canned motor (10) has two phases.

11. Expansion valve arrangement for a cooling or air-conditioning circuit according to one of the preceding claims, wherein phases of the canned motor (10) can be driven sinusoidally.

## Revendications

1. Arrangement de vanne d'expansion pour un circuit de refroidissement ou de conditionnement d'air, qui comprend :
un boîtier d'écoulement (4) avec une entrée (6) et une sortie (8),
un moteur synchrone (10) avec un carter de moteur (12), lequel moteur synchrone (10) est, par l'intermédiaire d'un arrangement de filetage (14), relié fonctionnellement à un élément d'accouplement (16) avec un corps de contrôle (20), de telle sorte que l'élément d'accouplement (16) avec le corps de contrôle (20) peut être déplacé axialement, au moins une section d'écoulement (22) entre l'entrée (6) et la sortie (8), laquelle section d'écoulement (22) est entourée par un siège de vanne (24) et peut être fermée et ouverte au moyen du corps de contrôle (20),
dans lequel
le moteur synchrone (10) est un moteur à boîte, à l'intérieur d'une boîte (26) duquel est disposé un arrangement de rotor (32), lequel arrangement de rotor (32) comprend une partie de cylindre de rotor (42), des moyens de connexion de rotor (48), une partie de filetage interne (50) et des moyens de palier (56), dans lequel des régions d'aimant permanent (44, 46), qui s'étendent dans la direction longitudinale et sont disposées en alternance par rapport à la polarité, sont prévues sur la partie de cylindre de rotor (42), la partie cylindrique du rotor (42) est reliée, par l'intermédiaire du moyen de connexion du rotor (48), de manière à pouvoir tourner avec la partie filetée intérieure (50) qui s'engage dans un filetage extérieur (54) de l'élément d'accouplement (16), la partie filetée intérieure (50) est supportée de manière à pouvoir tourner dans le carter d'écoulement (4) par l'intermédiaire du moyen de palier (56), un senseur de Hall (62) est prévu dans le carter du moteur (12) pour détecter une position de la partie cylindrique du rotor (42).

2. Arrangement de vanne d'expansion pour un circuit de refroidissement ou de conditionnement d'air selon la revendication 1, dans lequel un stator (38) du moteur à boîte (10) est un stator à pôles à griffes.

3. Arrangement de vanne d'expansion pour un circuit de refroidissement ou de climatisation selon la revendication 1 ou 2, dans lequel la boîte (26) du moteur à boîte (10) est serrée dans le boîtier d'écoulement (4) de manière étanche.

4. Arrangement de vanne d'expansion pour un circuit de refroidissement ou de climatisation selon les revendications 2 et 3, dans lequel la boîte (26) est une pièce en tôle, dont une partie tubulaire (40) est supportée dans le stator à pôles à griffes (38).

5. Arrangement de vanne d'expansion pour un circuit de refroidissement ou de climatisation selon l'une des revendications précédentes, dans lequel les moyens de connexion du rotor (48) pour la partie filetée interne (50) sont en forme de cloche, l'élément de couplage (16) pouvant être guidé par une partie inférieure (58) des moyens de connexion du rotor (48).

6. Arrangement de vanne d'expansion pour un circuit de refroidissement ou de climatisation selon l'une des revendications précédentes, dans lequel le senseur de Hall (62) est un senseur de Hall double avec deux plans de Hall.

7. Arrangement de vanne d'expansion pour un circuit de refroidissement ou de climatisation selon l'une des revendications précédentes, dans lequel les zones d'aimant permanent (44, 46) sont réalisées sous la forme d'un aimant cylindrique, moulé par injection et lié par du plastique.

8. Arrangement de vanne d'expansion pour un circuit de refroidissement ou de climatisation selon l'une des revendications 1 - 6, dans lequel les zones d'aimant permanent (44, 46) sont réalisées sous forme de bandes d'aimant permanent qui sont disposées dans des évidements correspondants de la partie cylindrique du rotor (42).

9. Arrangement de vanne d'expansion pour un circuit de refroidissement ou de climatisation selon l'une des revendications précédentes, dans lequel une unité de contrôle (60) est prévue dans le carter du moteur (12), au niveau de laquelle est disposé le senseur de Hall (62).

10. Arrangement de vanne d'expansion pour un circuit de refroidissement ou de climatisation selon l'une des revendications précédentes, dans lequel le moteur à boîte (10) a deux phases.

11. Arrangement de vanne d'expansion pour un circuit de refroidissement ou de climatisation selon l'une des revendications précédentes, dans lequel les phases du moteur à boîte (10) peuvent être commandées de manière sinusoïdale.
